# EUROPEAN PATENT APPLICATION

(11) **EP 4 779 323 A1**
(43) Date of publication of application: **22.07.2026**
(21) Application number: 24851848.2
(22) Date of filing: 06.08.2024
(51) Int. Cl.: G01R 15/18

(54) **CURRENT SENSOR, MEASUREMENT DEVICE, AND MEASUREMENT METHOD**

(30) Priority: 10.08.2023 JP 2023131572; 05.08.2024 JP 2024128748
(71) Applicant: Hioki E.E. Corporation, Ueda-shi, Nagano 386-1192 (JP)
(72) Inventor: IKEDA Kenta, Ueda-shi, Nagano 386-1192 (JP); KARASAWA Yuki, Ueda-shi, Nagano 386-1192 (JP); KOMIYAMA Tetsuya, Ueda-shi, Nagano 386-1192 (JP)
(74) Representative: Novagraaf International SA
(86) International application number: PCT/JP2024/028065
(87) International publication number: WO 2025/033424

(57) **Abstract**

To improve current detection accuracy by a current sensor. A current sensor (3) includes a fluxgate (32), a first core (31) made of a magnetic material, the first core (31) having an annular configuration and including an accommodation space (314) accommodating the fluxgate (32), and a signal generation circuit (50) generating a signal based on magnetic flux detected by the fluxgate (32), and detects a current flowing through a measurement target in a state in which the measurement target (5) is inserted through the first core. In the current sensor (3), the fluxgate (32) includes a second core (321) made of a magnetic material and extending in the accommodation space (314), and a coil (323) wound around the second core (321) along an extending direction of the second core (321). One end portion of the second core (321) in the extending direction is in contact with a portion of the first core (31), and the other end portion of the second core (321) in the extending direction is in contact with another portion of the first core (31).

## Description

### TECHNICAL FIELD

The present invention relates to a current sensor and a measurement device, and relates to, for example, a current sensor including a fluxgate detecting magnetic flux, a measurement device including the current sensor, and a measurement method using the current sensor.

### BACKGROUND ART

In the related art, a current sensor including a fluxgate detecting magnetic flux is known as a detector for detecting a current flowing through a conductor. For example, Patent Document 1 discloses a current sensor including a core constituted by a magnetic material.

The current sensor disclosed in Patent Document 1 includes the core formed in an annular shape having an air gap, and the fluxgate is provided in the vicinity of the air gap of the core. The current sensor outputs a signal corresponding to the current flowing through the conductor by detecting, with the fluxgate, the magnetic flux based on a magnetic field generated by the current flowing through the conductor, in a case in which the core is arranged in an annular shape so as to surround the conductor of the measurement target. According to the current sensor, since the fluxgate is arranged in the air gap of the core, the magnetic flux passing through the fluxgate increases, and the current detection accuracy can be improved.

### CITATION LIST

### PATENT LITERATURE

Patent Document 1: JP 2017-53810 A

### SUMMARY OF INVENTION

### TECHNICAL PROBLEM

However, in recent years, in order to develop devices having high energy efficiency, higher accuracy in current measurement has been required, and a current sensor having higher current detection accuracy than a current sensor in the related art represented by Patent Document 1 has been demanded.

The present invention has been made in view of the above-described problem, and an object of the present invention is to improve current detection accuracy by a current sensor.

### SOLUTION TO PROBLEM

A current sensor according to a typical embodiment of the present invention includes a fluxgate configured to detect magnetic flux, a first core made of a magnetic material, the first core having an annular configuration and including an accommodation space configured to accommodate the fluxgate, and a signal generation circuit configured to generate a signal based on magnetic flux detected by the fluxgate, and detects a current flowing through a measurement target in a state in which the measurement target is inserted into the first core. In the current sensor, the fluxgate includes a second core made of a magnetic material and extending in the accommodation space and a coil wound around the second core along an extending direction of the second core, one end portion of the second core in the extending direction being in contact with a portion of the first core, and the other end portion of the second core in the extending direction being in contact with another portion of the first core.

### ADVANTAGEOUS EFFECTS OF INVENTION

According to the current sensor of the present invention, current detection accuracy can be improved.

### BRIEF DESCRIPTION OF DRAWINGS

FIG. 1 is a diagram illustrating a configuration of a measurement device according to Embodiment 1.
FIG. 2A is a diagram illustrating principle of current detection by a current sensor.
FIG. 2B is a diagram illustrating the principle of current detection by the current sensor.
FIG. 3 is a perspective view illustrating an appearance of the current sensor according to Embodiment 1.
FIG. 4 is a diagram illustrating an appearance of a sensor portion.
FIG. 5 is a diagram illustrating an appearance of a magnetic detection portion.
FIG. 6 is a front view illustrating an appearance of a first core according to Embodiment 1.
FIG. 7 is a perspective view illustrating the first core according to Embodiment 1.
FIG. 8 is an exploded perspective view (partial) illustrating the first core according to Embodiment 1.
FIG. 9 is a cross-sectional view illustrating the first core according to Embodiment 1.
FIG. 10 is an exploded perspective view (entire) illustrating the first core according to Embodiment 1.
FIG. 11 is a diagram schematically illustrating a positional relationship between a second core and the first core in the current sensor according to Embodiment 1.
FIG. 12 is a front view illustrating an appearance of a first core according to Embodiment 2.
FIG. 13 is an exploded perspective view (partial) illustrating the first core according to Embodiment 2.
FIG. 14 is an exploded perspective view (entire) illustrating the first core according to Embodiment 2.
FIG. 15 is a diagram schematically illustrating a positional relationship between a second core and the first core in a current sensor according to Embodiment 2.
FIG. 16 is a diagram illustrating another arrangement example of a fluxgate.
FIG. 17 is a diagram schematically illustrating the current sensor in which the second core and the first core are integrally formed.
FIG. 18 is a diagram illustrating another example of a positional relationship between the second core and the first core in the current sensor.
FIG. 19 is a diagram illustrating another example of a positional relationship between the second core and the first core in the current sensor.
FIG. 20 is a diagram illustrating another example of a positional relationship between the second core and the first core in the current sensor.
FIG. 21 is a diagram illustrating another example of a positional relationship between the second core and the first core in the current sensor.
FIG. 22 is a diagram illustrating another example of a positional relationship between the second core and the first core in the current sensor.
FIG. 23A is a perspective view illustrating an appearance of a through-type current sensor in which the first core is formed annularly.
FIG. 23B is a front view illustrating an appearance of the through-type current sensor in which the first core is formed annularly.
FIG. 24 is a diagram illustrating an example of the first core that is formed by a plurality of magnetic members.
FIG. 25 is a diagram illustrating a circuit example of a magnetic balance type current sensor using a fluxgate pair including two fluxgates as a set.
FIG. 26 is a diagram illustrating a configuration of the magnetic balance type current sensor using the fluxgate pair including the two fluxgates as a set.
FIG. 27 is a diagram schematically illustrating magnetic flux formed around the fluxgate pair including two fluxgates as a set.

### DESCRIPTION OF EMBODIMENTS

### 1. Overview of Embodiments

First, an overview of typical embodiments of the invention disclosed in the present application will be described. Note that, in the following description, reference signs in the drawings corresponding to structural elements of the invention are shown in parentheses, for example.
[1] A current sensor (3, 3A to 3H, 3J, and 3K) according to a typical embodiment of the present invention includes a fluxgate (32, 32A, 32B, 32C, 32K_1, and 32K_2) detecting magnetic flux, an annular first core (31, 31_1, and 31_2) made of a magnetic material and including an accommodation space (314, 314K_1, and 314K_2) accommodating the fluxgate, and a signal generation circuit (50, 50A, and 50K) generating a signal based on magnetic flux detected by the fluxgate, and detects a current flowing through a measurement target (5) in a state in which the measurement target is inserted through the first core. In the current sensor, the fluxgate includes a second core (321, 321A, 321B, 321C, and 321K) made of a magnetic material and extending in the accommodation space, and a coil (323, 323K_1, and 323K_2) wound around the second core along a direction in which the second core extends, and one end portion in the extending direction of the second core is in contact with a portion of the first core, and the other end portion in the extending direction of the second core is in contact with another portion of the first core.
[2] In the current sensor (3, 3A to 3H, 3J, and 3K) according to item [1], the second core may extend in a circumferential direction of the first core.
[3] In the current sensor (3, 3A to 3H, 3J, and 3K) according to item [1] or item [2], the first core may be continuously provided in the circumferential direction of the first core at an outer peripheral side of the first core around the accommodation space.
[4] In the current sensor (3, 3A to 3H, 3J, and 3K) according to any one of items [1] to [3], the first core may be continuously provided in the circumferential direction of the first core at an inner peripheral side of the first core around the accommodation space.
[5] In the current sensor (3, 3A, 3B, 3C, 3E to 3H, 3J, and 3K) according to any one of items [1] to [4], when one surface of the first core in an insertion direction (P, Z-axis direction) of the measurement target 5 in the first core is an upper surface (310_1) and another surface in the insertion direction of the measurement target 5 in the first core is a lower surface (310_8), the first core may be continuously provided in the circumferential direction of the first core on at least one of the upper surface and the lower surface around the accommodation space.
[6] In the current sensor (3, 3A, 3B, 3C, 3E to 3H, 3J, and 3K) according to any one of items [3] to [5], a portion being continuously provided in the circumferential direction of the first core may be integrally formed.
[7] In the current sensor (3, 3A to 3H, 3J, and 3K) according to any one of items [1] to [6], the one end portion (321Aa) in the extending direction of the second core (321A) and the other end portion (321Ab) in the extending direction of the second core may be covered by the first core.
[8] In the current sensor (3, 3A to 3H, 3J, and 3K) according to any one of items [1] to [7], the first core (31) is formed by a plurality of plate-like members (310_1 to 310_8) made of a magnetic material and stacked in the insertion direction of the measurement target 5 in the first core, and the one end portion (321Aa) in the extending direction of the second core and the other end portion (321Ab) in the extending direction of the second core may be interposed between two of the plate-like members (310_4 and 310_5) in the insertion direction.
[9] In the current sensor (3, 3A to 3H, 3J, and 3K) according to any one of items [1] to [8], the current sensor may have a plurality of the fluxgates.
[10] In the current sensor (3K) according to item [9], the current sensor (3K) may include at least one fluxgate pair (32KP) including two fluxgates as one set, a first fluxgate (32K_1) and a second fluxgate (32K_2) constituting the fluxgate pair and sharing the second core (321K), the coil of the first fluxgate and the coil of the second fluxgate being wound respectively around the second core shared by the first fluxgate and the second fluxgate.
[11] In the current sensor (3K) according to item [10], the accommodation space may include a first accommodation space (314K_1) accommodating the first fluxgate and a second accommodation space (314K_2) accommodating the second fluxgate, the first accommodation space and the second accommodation space being formed side by side in the circumferential direction of the first core, the first core being continuously provided between the first accommodation space and the second accommodation space.
[12] In the current sensor (3, 3A to 3H, 3J, and 3K) according to any one of items [1] to [11], the first core (31, 31_1, 31_2, and 31K) and the second core (321, 321A, 321B, 321C, and 321K) may be integrally formed. At this time, the first core and the second core may be made of the same magnetic material.
[13] In the current sensor (3, 3A to 3H, 3J, and 3K) according to any one of items [1] to [12], the current sensor may detect the current by a zero flux method.
[14] A typical measurement device (1) according to the present embodiment may include a current sensor (3, 3A to 3H, 3J, and 3K) according to any one of items [1] to [13], and a measurement device main body (2) measuring the current flowing through the measurement target based on the signal generated by the current sensor in a state in which the first core surrounds the measurement target and forms an annular shape.
[15] A typical measurement method according to the present embodiment is a measurement method for measuring a current flowing through the measurement target by using a current sensor (3, 3A to 3H, 3J, and 3K). The current sensor includes a fluxgate (32, 32A, 32B, 32C, 32K_1, and 32K_2) detecting magnetic flux, a first core (31, 31_1, and 31_2) made of a magnetic material, the first core having an annular configuration and including an accommodation space (314, 314K_1, and 314K_2) accommodating the fluxgate, and a signal generation circuit (50, 50A, and 50K) generating a signal based on the magnetic flux detected by the fluxgate, the fluxgate including a second core (321, 321A, 321B, 321C, and 321K) made of a magnetic material and extending in the accommodation space and coils (323, 323K_1, and 323K_2) wound around the second core along the extending direction of the second core, one end portion in the extending direction of the second core being in contact with a portion of the first core and the other end portion in the extending direction of the second core being in contact with another portion of the first core. The measurement method includes a first step of inserting the measurement target into the first core, and a second step of measuring the current flowing through the measurement target based on the signal generated by the signal generation circuit.

### 2. Specific Examples of Embodiments

Hereinafter, specific examples of the embodiments of the present invention will be described with reference to the drawings. Note that, in the following description, the same reference signs are assigned to structural elements that are common to each of the embodiments, and a repeated description thereof will be omitted. Further, the drawings are schematic, and note that relationships of dimensions of respective elements, ratios of the respective elements, and the like may differ from actual ones. Even between the drawings, portions in which relationships of dimensions and ratios differ from one another may be included.

### Embodiment 1

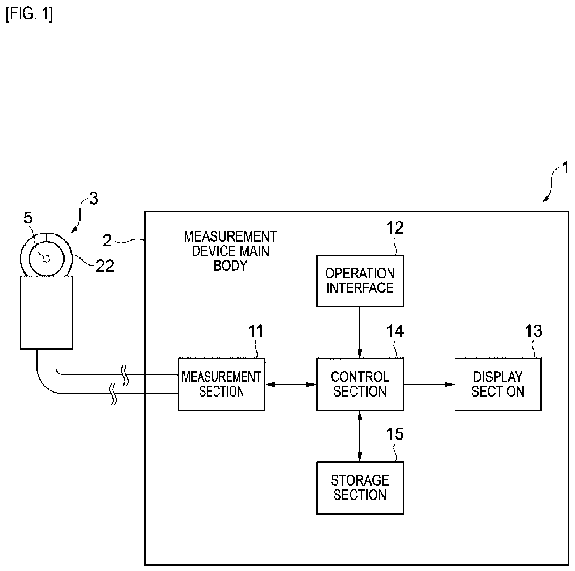

As illustrated in FIG. 1, a measurement device 1 according to Embodiment 1 is, for example, a current measurement device measuring a current flowing through a measurement target 5 (for example, a conductive wire). The measurement device 1 is configured to measure the current flowing through the measurement target 5 in an electrically non-contact state with respect to the measurement target 5.

Specifically, the measurement device 1 includes a current sensor 3 and a measurement device main body 2. For example, in a state in which the measurement target 5 is annularly surrounded by the current sensor 3, the current sensor 3 detects the current flowing through the measurement target 5, and the measurement device main body 2 measures (calculates) the current value of the current flowing through the measurement target 5 based on the detection result by the current sensor 3.

The current sensor 3 is a device detecting the current flowing through the measurement target 5 and outputting a signal corresponding to the detection result. The current sensor 3 is a sensor detecting the current flowing through the measurement target 5 in a non-contact manner in a state with the measurement target 5 annularly surrounded, and may exemplify a so-called through-type current sensor or a so-called clamp-type current sensor. In the present embodiment, a case in which the current sensor 3 is a clamp-type current sensor will be mainly described as an example.

As described below, the current sensor 3 includes, as main structural elements, a first core 31 made of a magnetic material and a fluxgate 32 arranged inside the first core 31 and including a second core, and detects the current by detecting magnetic flux passing through the second core of the fluxgate 32 through the first core 31 by the fluxgate 32.

In the following description, the first core 31 may be referred to as a "main core 31".

The measurement device main body 2 is a device measuring (calculating) a current value of the current flowing through the measurement target 5 based on the detection result (output signal Vout) by the current sensor 3. The measurement device main body 2 measures the current flowing through the measurement target 5 based on the output signal Vout generated by the current sensor 3 in a state in which the main core 31 surrounds the measurement target 5 and forms an annular shape.

As illustrated in FIG. 1, the measurement device main body 2 includes, for example, a measurement section 11, an operation interface 12, a display section 13, a control section 14, and a storage section 15.

The measurement section 11 is a functional section that, in response to control from the control section 14, calculates the current value of the current flowing through the measurement target 5 based on the output signal Vout as the detection result of current output from the current sensor 3. The measurement section 11 is realized by a program processing device such as a microcontroller, for example.

The operation interface 12 is a user interface for inputting instructions or the like to the measurement device 1 by a user. The operation interface 12 is realized by, for example, an operation switch, a keyboard, a touch panel, or the like. The operation interface 12 outputs an operation signal corresponding to an operation performed on the operation interface 12 by the user to the control section 14. By operating the operation interface 12, the user can set information relating to measurement conditions in the measurement device 1, for example, and instruct start and stop of measurement to the measurement device 1.

Note that, settings of measurement conditions and the like, and instructions and the like to the measurement device 1 are not limited to operations on the operation interface 12 described above, and, for example, may be input from information processing devices such as a personal computer, a server, and a mobile terminal connected to the measurement device 1 by wired communication or wireless communication.

The display section 13 is a device displaying various kinds of information. The display section 13 is realized by a device that outputs information visually recognizable by the user, such as a liquid crystal display or an organic EL display. The display section 13 displays, in accordance with control from the control section 14, for example, menu information for inputting measurement conditions, information on a measurement result of a current value of the current flowing through the measurement target 5, and the like.

The storage section 15 is a functional section for storing, for example, a program and various parameters for enabling the measurement device 1 to realize a function as a current measurement device, as well as measurement results, and the like of the measurement target 5. The storage section 15 is realized by, for example, nonvolatile storage devices such as SSDs, HDDs, and the like.

The control section 14 is a functional section that comprehensively controls the measurement device 1. The control section 14 is realized by, for example, a program processing device such as a microcontroller, and the like, similarly to the measurement section 11. The control section 14 realizes measurement of the current flowing through the measurement target 5, storage of the measurement result, and display of the measurement result by controlling the measurement section 11, the display section 13, and the storage section 15 in accordance with an operation signal from the operation interface 12.

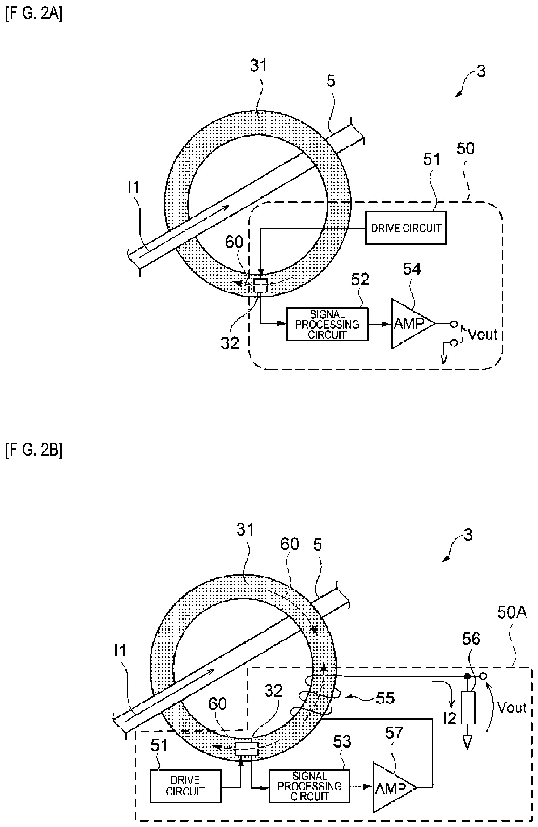

Here, a current detection method by the current sensor 3 will be described with reference to FIGS. 2A and 2B.

FIG. 2A illustrates a magnetic proportional (open-loop) current detection method, and FIG. 2B illustrates a magnetic balance (closed-loop, zero flux) current detection method.

As illustrated in FIG. 2A, in the magnetic proportional current detection method, the main core 31 annularly surrounds the measurement target 5 (for example, a conductive wire). In this state, the fluxgate 32 arranged inside the main core 31 detects magnetic flux 60 generated inside the main core 31 by a current I1 flowing through the measurement target 5, and the signal generation circuit 50 generates the output signal Vout based on the magnetic flux 60 detected by the fluxgate 32.

The signal generation circuit 50 includes, for example, a drive circuit 51, a signal processing circuit 52, and an amplification circuit (AMP) 54. The fluxgate 32 is operable by power supplied from the drive circuit 51. The fluxgate 32 generates a voltage corresponding to the detected magnetic flux 60. The signal processing circuit 52 generates a voltage obtained by synchronous detection or a voltage obtained by pulse width modulation of a voltage generated by the fluxgate 32. The amplification circuit 54 amplifies the voltage generated by the signal processing circuit 52 and outputs the amplified voltage as the output signal Vout.

As illustrated in FIG. 2B, in the magnetic balance current detection method, similarly to the magnetic proportional current detection method, in a state in which the measurement target 5 is annularly surrounded by the main core 31, the fluxgate 32 detects the magnetic flux 60 generated in the main core 31 by the current I1 flowing through the measurement target 5, and a signal generation circuit 50A generates an output signal Vout based on the magnetic flux 60 detected by the fluxgate 32.

The signal generation circuit 50A includes a drive circuit 51, a signal processing circuit 53, an amplification circuit (AMP) 57, a coil 55 wound around the main core 31, and a voltage generation circuit (for example, a shunt resistor) 56. The fluxgate 32 is operable by power supplied from the drive circuit 51. The fluxgate 32 detects the magnetic flux 60 generated by the current I1 flowing through the measurement target 5 and generates the voltage corresponding to the detected magnetic flux 60. The signal processing circuit 53 generates a voltage obtained by synchronous detection or a voltage obtained by pulse width modulation of the voltage generated by the fluxgate 32, and outputs the current obtained by converting the voltage.

The amplification circuit 57 supplies the current I2 to the coil 55 based on the current output from the signal processing circuit 53 so as to generate magnetic flux 61 canceling the magnetic flux 60 (magnetic flux generated by the current I1) detected by the fluxgate 32 (zero flux operation). The voltage generation circuit (for example, a shunt resistor) 56 converts the current I2 flowing through the coil 55 into a voltage and outputs the voltage as the output signal Vout.

Next, the configuration of the current sensor 3 will be described. Note that, in the present embodiment, as one example, the current sensor 3 is described as having a configuration for performing current detection by the magnetic balance method.

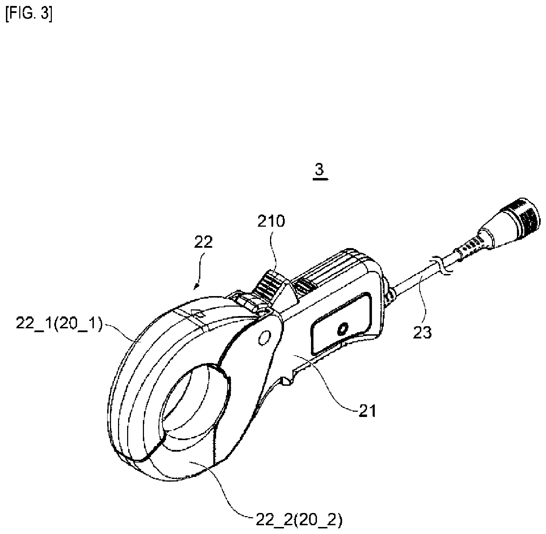

As illustrated in FIG. 3, the current sensor 3 includes, for example, a gripping portion 21, a sensor portion 22, and a connection cable 23.

The sensor portion 22 includes the main core 31 and the fluxgate 32 as primary structural elements of the current sensor 3 described above and is configured to clamp the measurement target 5. Here, clamp refers to annularly surrounding the measurement target 5 (for example, a conductive wire).

The sensor portion 22 is configured to be annularly openable and closable (deformable). For example, as illustrated in FIG. 3, the sensor portion 22 is realized by combining a first sensor portion 22_1 and a second sensor portion 22_2 each configured to have a semi-annular shape in a front view.

One circumferential end of the first sensor portion 22_1 and one circumferential end of the second sensor portion 22_2 are configured to contact each other. As illustrated in FIG. 3, the sensor portion 22 (main core 31) forms a single annular shape by one circumferential end of the first sensor portion 22_1 and one circumferential end of the second sensor portion 22_2 contacting each other.

Note that, details of configurations of the first sensor portion 22_1 and the second sensor portion 22_2 will be described below.

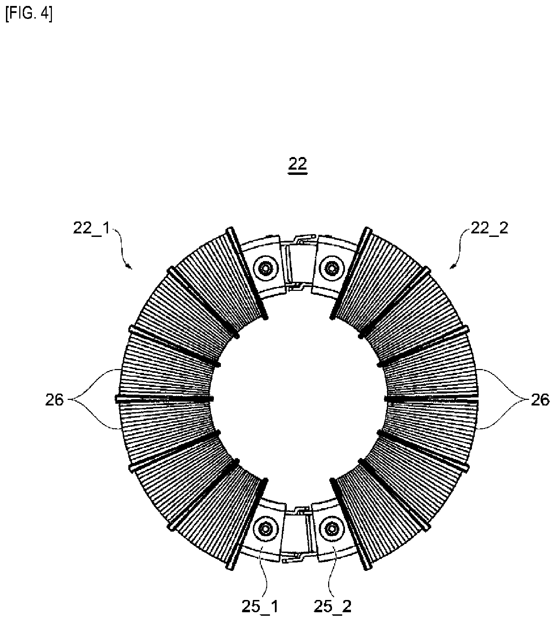

The gripping portion 21 is a portion gripped by the user during clamping work of the measurement target 5 by the sensor portion 22. As illustrated in FIG. 3, the sensor portion 22 is disposed on one end portion side (left end portion side in FIG. 3) of the gripping portion 21. Inside the gripping portion 21, a circuit board (not illustrated) on which the above-described signal generation circuit 50A (50) is configured is accommodated. Further, from the other end portion side of the gripping portion 21 (right end portion side in FIG. 4), the connection cable 23 connected to the signal generation circuit 50A (50) is led out. The connection cable 23 inputs the detection result by the current sensor 3 into the measurement device 1. Specifically, the connection cable 23 is configured to include a conductive wire for inputting the output signal Vout output from the signal generation circuit 50A (50) to the measurement device 1.

The gripping portion 21 is provided with an opening/closing operation portion 210 for performing an opening and closing operation of the sensor portion 22. For example, when the opening/closing operation portion 210 is not operated by the user, the first sensor portion 22_1 and the first sensor portion 22_1 are brought into a state in which one circumferential end of the first sensor portion 22_1 and one circumferential end of the second sensor portion 22_2 are in contact with each other by a biasing means such as a spring. On the other hand, when the user presses down the opening/closing operation portion 210, at least one of the above one end portion of the first sensor portion 22_1 and the above one end portion of the second sensor portion 22_2 moves in a direction away from the other, and the above one end portion of the first sensor portion 22_1 and the above one end portion of the second sensor portion 22_2 brought into a non-contact state.

As illustrated in FIG. 3, for example, the first sensor portion 22_1 and the second sensor portion 22_2 are respectively covered by resin cases 20_1 and 20_2.

In FIG. 4, the sensor portion 22 in a state in which the cases 20_1 and 20_2 are removed is illustrated.
As illustrated in FIG. 4, the first sensor portion 22_1 includes a magnetic detection portion 25_1 detecting magnetic flux and a coil 26 wound around the periphery of the magnetic detection portion 25_1. Similarly, the second sensor portion 22_2 includes a magnetic detection portion 25_2 detecting magnetic flux and the coil 26 wound around the magnetic detection portion 25_2. The coil 26 constitutes the coil 55 in the above-described signal generation circuit 50A.

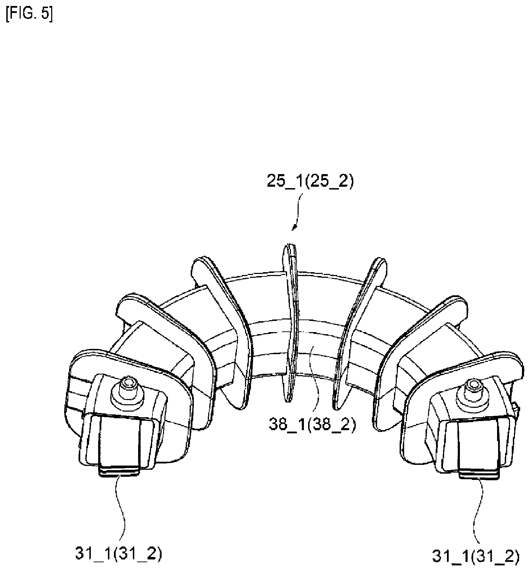

In FIG. 5, appearances of the magnetic detection portion 25_1 and the magnetic detection portion 25_2 are illustrated.
Since the magnetic detection portion 25_1 and the magnetic detection portion 25_2 illustrated in FIG. 4 have substantially the same configuration, only the magnetic detection portion 25_1 as a typical example is illustrated in FIG. 5, and illustration of the magnetic detection portion 25_2 is omitted. Further, in FIG. 5, illustration of the coil 26 is omitted.

As illustrated in FIGS. 4 and 5, the magnetic detection portions 25_1 and 25_2 respectively include, for example, covers 38_1 and 38_2 around which the coil 26 is wound, and main cores 31_1 and 31_2 accommodated in the covers 38_1 and 38_2. Further, the magnetic detection portions 25_1 and 25_2 respectively include the fluxgates 32 arranged inside the main cores 31_1 and 31_2. Note that, in Embodiment 1, the main core 31 is composed of the main cores 31_1 and 31_2.

The covers 38_1 and 38_2 are configured to accommodate the main cores 31_1 and 31_2 and the fluxgate 32, and are provided with a plurality of flange portions for preventing winding collapse so as to function as bobbins for winding the coil 26 around the main cores 31_1 and 31_2.

Note that, in FIG. 4, although a case in which the coil 26 is wound around the main cores 31_1 and 31_2 via the covers 38_1 and 38_2 is exemplified, the coil 26 may be directly wound around the main cores 31_1 and 31_2 without providing the covers 38_1 and 38_2, for example.

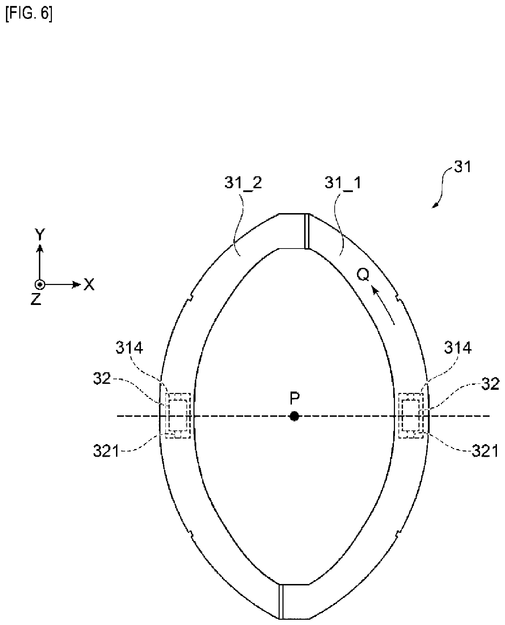

FIG. 6 illustrates a front view of the main cores 31_1 and 31_2 in a state in which the sensor portion 22 is annular. FIG. 6 illustrates a case in which the main cores 31_1 and 31_2 are arranged in a three-dimensional space constituted by three reference axes including the X-axis, the Y-axis, and the Z-axis, such that the circumferential direction of the main core 31_1 is parallel to the X-Y plane.

The main core 31_1 and 31_2 are formed of a magnetic material (magnetic member). Examples of a magnetic material forming the main cores 31_1 and 31_2 include a nickel-iron alloy (so-called permalloy, PC permalloy) containing 35% to 80% of nickel Ni having ferromagnetism, an amorphous magnetic material.

The main cores 31_1 and 31_2 are configured to have a semi-annular shape in a front view so as to match a shape of the sensor portion 22. For example, when the measurement target 5 is clamped by the sensor portion 22, that is, when one end portion in the circumferential direction of the first sensor portion 22_1 and one end portion in the circumferential direction of the second sensor portion 22_2 come into contact with each other and the first sensor portion 22_1 and the second sensor portion 22_2 form an annular shape, one end portion in a circumferential direction Q of the main core 31_1 and one end portion in the circumferential direction Q of the main core 31_2 come into contact with each other, and the other end portion in the circumferential direction Q of the main core 31_1 and the other end portion in the circumferential direction Q of the main core 31_2 come into a contact state with each other. Accordingly, as illustrated in FIG. 6, one annular main core 31 is formed.

More specifically, the main core 31 composed of the main cores 31_1 and 31_2 is configured to become annular in a state in which the measurement target 5 is surrounded when the current flowing through the measurement target 5 is measured (when the measurement target 5 is clamped).

For example, when the opening/closing operation portion 210 in the gripping portion 21 is not operated, the above one end portion of the main core 31_1 and the above one end portion of the main core 31_2 are brought into a contact state. On the other hand, while the opening/closing operation portion 210 is pressed down, at least one of the first sensor portion 22_1 and the second sensor portion 22_2 moves in a direction away from the other, and the one end portion described above of the main core 31_1 and the one end portion described above of the main core 31_2 are brought into a non-contact state. Thus, in the clamp-type current sensor, the main core 31 is configured to be annularly deformable (openable and closable).

Here, the annular shape may be, for example, a circular shape (for example, a perfect circular shape or an elliptical shape) in a front view, or may be a rectangular shape or a polygonal shape in a front view. In Embodiment 1, as one example, as illustrated in FIG. 6, the main core 31_1 and the main core 31_2 are in contact with each other in the circumferential direction and constitute one main core 31 having an elliptical shape in a front view. Note that the main cores 31_1 and 31_2 may be integrally formed in an annular shape.

The main core 31 includes an accommodation space 314 accommodating the fluxgate 32. For example, as illustrated in FIG. 6, in the sensor portion 22, the main core 31 accommodates a plurality of fluxgates 32, and the fluxgates 32 are arranged spaced apart from each other. Note that the number of fluxgates 32 arranged in the main core 31 may be one.

In Embodiment 1, as one example, one fluxgate 32 is accommodated in the accommodation space 314 of the main core 31_1, and one fluxgate 32 is accommodated in the accommodation space 314 of the main core 31_2. Further, as illustrated in FIG. 6, the two fluxgates 32 are arranged at positions that are point-symmetric to each other with respect to a center or a centroid P of the annular main core 31 when the annular main core 31 is viewed from an insertion direction of the measurement target 5 in the main core 31.

Next, the structure of the main cores 31_1 and 31_2 will be described in detail.
In Embodiment 1, the main core 31_1 and the main core 31_2 are assumed to have the same structure, and the structure of the main core 31_1 will be described in detail as a typical example.

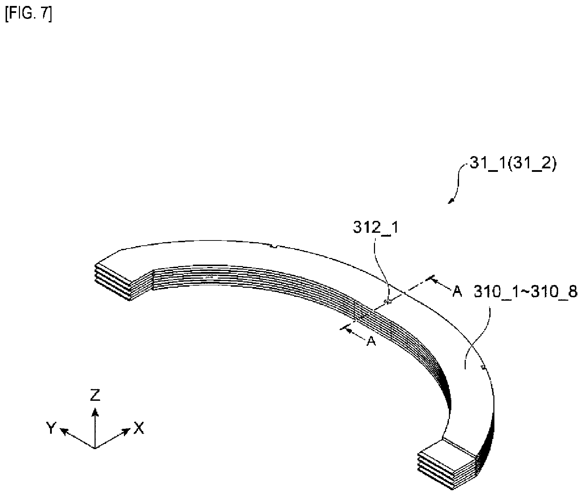

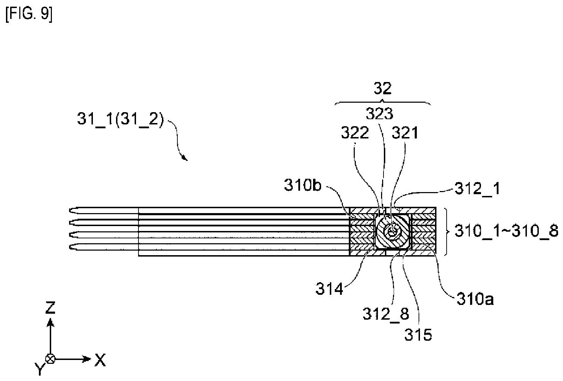

FIGS. 7 to 10 illustrate the configuration of the main core 31_1. FIGS. 7 to 10 illustrate a case in which, in the three-dimensional space defined by three reference axes including the X-axis, the Y-axis, and the Z-axis, the main core 31_1 is arranged such that the circumferential direction of the main core 31_1 is parallel to the X-Y plane. Further, FIG. 9 illustrates a cross-sectional shape of the main core 31_1 in the A-A cross section in FIG. 7.

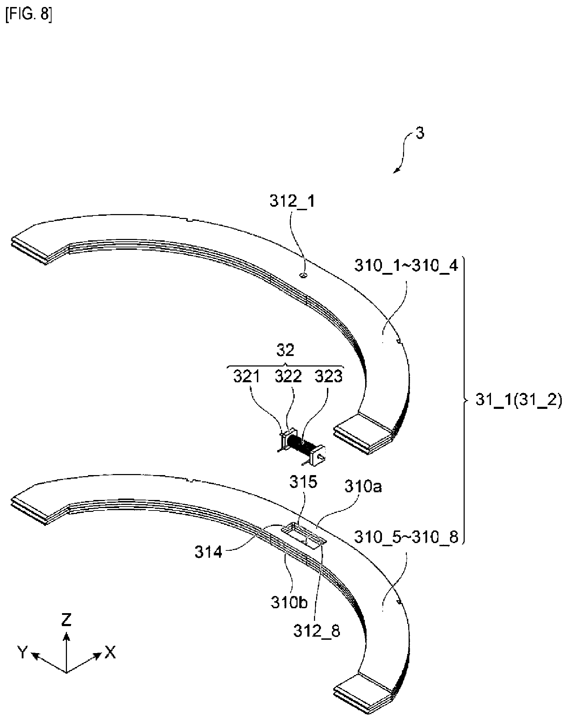

As illustrated in FIGS. 8 to 10, the fluxgate 32 is arranged in the accommodation space 314 inside the main core 31_1. Note that the entire fluxgate 32 does not necessarily need to be accommodated in the accommodation space 314, and a portion of the fluxgate 32 may extend outside the accommodation space 314. In this case, a portion of the fluxgate 32 extending outside the accommodation space 314 is preferably covered by the main core 31.

The fluxgate 32 is an example of a fluxgate detecting magnetic flux. The fluxgate 32 includes, for example, a core 321 (an example of a second core) made of a magnetic material and a coil (winding) 323 wound around the core 321. The fluxgate 32 outputs, from the coil 323, a current corresponding to magnetic flux passing through the core 321.

More specifically, as illustrated in FIGS. 8 to 10, the fluxgate 32 further includes a bobbin 322 accommodating the core 321. The bobbin 322 is configured to have a hollow cylindrical shape. The core 321 is inserted through the hollow cylinder of the bobbin 322. The coil 323 is wound around an outer peripheral surface of the bobbin 322. The bobbin 322 is used for separating and insulating the core 321 and the coil 323 from each other, and for facilitating winding of the coil 323. The fluxgate 32 may be configured without the bobbin 322 by using other means (such as an insulating tape) instead of the bobbin 322.

The core 321 is constituted of a magnetic material (magnetic member). For example, the magnetic material constituting the core 321 is an amorphous magnetic material or permalloy (for example, PC permalloy). The magnetic material constituting the core 321 preferably has high permeability.

The core 321 is configured, for example, in a rod shape or a strip shape. In Embodiment 1, as one example, the core 321 is assumed to be formed into a thin plate shape extending in one direction.

The fluxgate 32 is covered by the main core 31, which is a magnetic material, as viewed from the positive X direction side, the negative X direction side, the positive Z direction side, or the negative Z direction side. For example, as illustrated in FIGS. 8 and 9, the fluxgate 32 is arranged in the accommodation space 314 formed inside the main core 31, and is surrounded by an inner wall 315 of the main core 31 defining the accommodation space 314.

As illustrated in FIG. 8, on the outer peripheral side of the main core 31 in the accommodation space 314 (the positive X-axis direction side of the accommodation space 314), the main core 31 is integrally formed in the circumferential direction Q. Specifically, a coupling portion 310a coupling the main core 31 in the circumferential direction Q is formed on the outer peripheral side of the accommodation space 314 of the main core 31. In other words, no air gap is formed in the main core 31 on the outer peripheral side of the accommodation space 314.
According to this configuration, the main core 31 integrally formed around the accommodation space 314 functions as a shield for the fluxgate 32, so that the fluxgate 32 is less likely to be affected by an external magnetic field from the outer peripheral side.

As illustrated in FIG. 8, the main core 31 is integrally formed in the circumferential direction Q on the inner peripheral side of the main core 31 in the accommodation space 314 (the negative X-axis direction side of the accommodation space 314). Specifically, a coupling portion 310b coupling the main core 31 in the circumferential direction Q is formed on the inner peripheral side of the accommodation space 314 of the main core 31. In other words, no air gap is formed in the main core 31 on the inner peripheral side of the accommodation space 314.
According to this configuration, the main core 31 integrally formed around the accommodation space 314 functions as a shield for the fluxgate 32, so that the fluxgate 32 is less likely to be affected by an external magnetic field from the inner peripheral side.

Further, when the annular main core 31 is viewed from the insertion direction (Z-axis direction) of the measurement target 5 in the main core 31, the core 321 (accommodation space 314) of the fluxgate 32 is covered by the main core 31. In other words, when one surface of the main core 31 in the insertion direction (Z-axis direction) of the measurement target 5 in the main core 31 is defined as an upper surface (a plate-like member 310_1 described below) and the other surface in the insertion direction of the measurement target 5 in the main core 31 is defined as a lower surface (a plate-like member 310_8 described below), the main core 31 is integrally formed in the circumferential direction Q on at least one surface of the upper surface and the lower surface.

For example, as illustrated in FIGS. 6 and 8, the main core 31 integrally formed around the accommodation space 314 functions as a shield for the fluxgate 32, and the core 321 of the fluxgate 32 becomes less likely to be affected by an external magnetic field from an insertion direction of the measurement target 5 in the main core 31 (Z-axis direction).

As illustrated in FIGS. 7 to 10, the main cores 31_1 and 31_2 include, for example, through holes 312_1 and 312_8 formed to penetrate from inner walls 315 of the main cores 31_1 and 31_2 to surfaces of the main cores 31_1 and 31_2. The holes 312_1 and 312_8 are holes for leading out wiring lines that connect the coil 323 of the fluxgate 32 arranged inside the main core 31 and the signal generation circuit 50A) provided outside the main core 31. For example, both ends of the conductive wire constituting the coil 323 are led out through the holes 312_1 and 312_8, respectively, and are connected to the signal processing circuit 53 (52) of the signal generation circuit 50A (50).

Here, the state in which "the fluxgate 32 is covered by the main core 31" includes not only a state in which the entire fluxgate 32 is completely covered by the main core 31, but also a state in which the above-described holes 312_1 and 312_8 and gaps (hereinafter referred to as holes and the like) are formed in the main core 31 and a portion of the fluxgate 32 is exposed from the holes and the like of the main core 31.

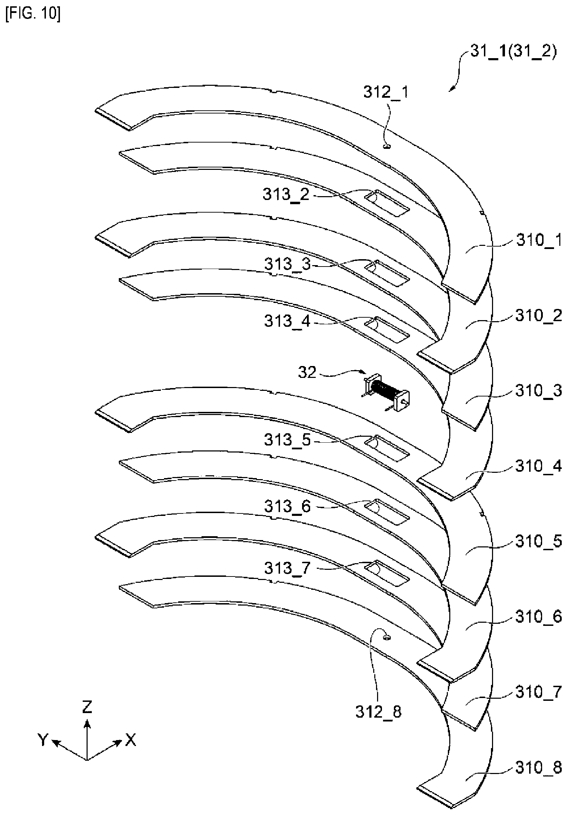

As illustrated in FIG. 10, the main core 31_1 (31_2) may be constituted, for example, by stacking a plurality of plate-like members 310_1 to 310_n (n being an integer of 2 or more) each having a semi-annular shape in a front view and made of a magnetic material. FIG. 10 illustrates, as one example, a case in which the main core 31_1 is configured by stacking eight (n = 8) plate-like members 310_1 to 310_8 in the Z-axis direction.

In FIG. 10, when a positive Z-axis direction is defined as upward and a negative Z-axis direction is defined as downward, holes (through holes) 313_2 to 313_7 defining the accommodation space 314 for accommodating the fluxgate 32 are respectively formed in intermediate-layer plate-like members 310_2 to 310_7 provided between the uppermost-layer plate-like member 310_1 and the lowermost-layer plate-like member 310_8. The holes 313_2 to 313_7 have an opening area for accommodating the fluxgate 32. In the uppermost-layer plate-like member 310_1 and the lowermost-layer plate-like member 310_8, the holes 312_1 and 312_8 for leading out the above-described wiring lines are respectively formed.

As illustrated in FIG. 10, by stacking the plate-like members 310_1 to 310_8 in the Z-axis direction, the accommodation space 314 formed by holes (through holes) 313_2 to 313_7 of the intermediate-layer plate-like members 310_2 to 310_7 is closed off, from the Z-axis direction, by the uppermost-layer plate-like member 310_1 and the lowermost-layer plate-like member 310_8. Accordingly, since the periphery of the core 321 of the fluxgate 32 is covered with the plate-like members 310_1 to 310_8, a structure less likely to be affected by an external magnetic field can be easily realized.

Note that the number of stacked intermediate-layer plate-like members 310 and the areas of the holes 313_2 to 313_7 are not limited to the examples illustrated in FIGS. 8 to 10, and may be changed according to the size and the like of the fluxgate 32 to be accommodated.

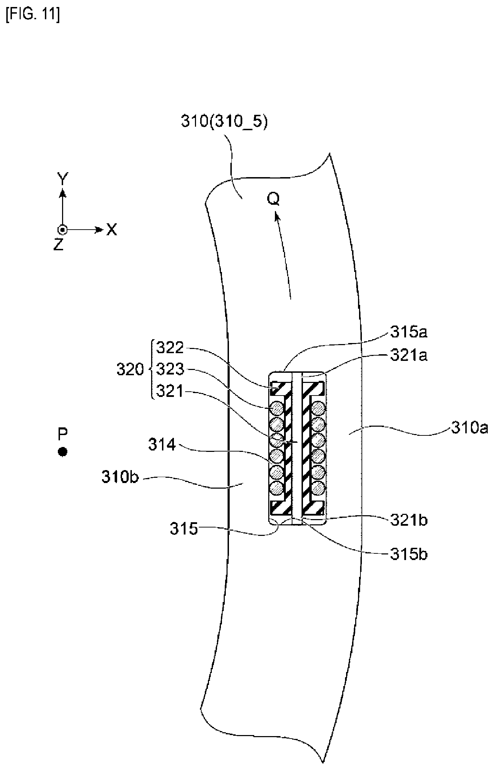

FIG. 11 is a diagram schematically illustrating a positional relationship between the fluxgate 32 and the main core 31 in the current sensor 3 according to Embodiment 1. FIG. 11 illustrates a cross-sectional structure of the fluxgate 32 accommodated in the main core 31 along the X-Y plane.

As illustrated in FIG. 11, the core 321 of the fluxgate 32 extends in the accommodation space 314. Specifically, the core 321 is arranged to extend along the circumferential direction Q of the annular main core 31. Note that, when the core 321 is arranged to extend along the circumferential direction Q of the annular main core 31, a length of the core 321 in the extending direction is not limited by the width of the main core 31 in the radial direction, so that the fluxgate 32 can be increased in size, and current detection accuracy can be improved.
The coil 323 is wound around the core 321 along the direction in which the core 321 extends.

One end portion 321a of the core 321 in the extending direction is in contact with a portion of the main core 31 in the circumferential direction Q, and the other end portion 321b of the core 321 in the extending direction is in contact with another portion of the main core 31 in the circumferential direction Q. For example, the end portion 321a of the core 321 is in contact with one surface in the circumferential direction Q of the inner wall 315 of the main core 31 defining the accommodation space 314, and 321b of the core 321 is in contact with the other surface in the circumferential direction of the inner wall 315. In FIG. 11, as one example, a case is illustrated in which both the end portions 321a and 321b of the core 321 are in contact with the inner wall 315 of the plate-like member 310_5.

According to the current sensor 3 having the structure described above, variation in the magnetic flux detection accuracy due to the position of the measurement target 5 (conductor) relative to the main core 31 can be suppressed, and degradation in the current detection accuracy can be suppressed.

That is, in the current sensor in the related art, the magnetic flux leaks from the air gap of the main core, so that the flow of the magnetic flux is generated outside the main core 31 and the core 321 of the fluxgate 32, and variation in detection accuracy occurs due to the influence of the flow of the magnetic flux. In contrast, the current sensor 3 having the above-described configuration includes a structure in which the one end portion 321a of the core 321 of the fluxgate 32 is in contact with a portion of the main core 31, and the other end portion 321b of the core 321 of the fluxgate 32 is in contact with another portion of the main core 31. In other words, the core 321 of the fluxgate 32 connects the air gap of the main core. Accordingly, since no air gap is formed, variation in the magnetic flux detection accuracy due to the position of the measurement target 5 (conductor) relative to the main core 31 is suppressed, and degradation in the current detection accuracy is suppressed.

Further, after assembling the fluxgate 32 by winding the coil 323 around the core 321 (bobbin 322), by arranging the fluxgate 32 in the accommodation space 314 of the main core 31, the one end portion of the core 321 in the extending direction can be brought into contact with the main core 31 facing the one end portion, and the other end portion of the core 321 in the extending direction can be brought into contact with the main core 31 opposing the other end portion. Thus, assembly of the current sensor 3 is facilitated.

Further, as described above, by adopting a structure in which the periphery of the fluxgate 32 arranged in the accommodation space 314 is covered with the main core 31, no separate component functioning as a magnetic shield is required to be additionally provided, so that a compact current sensor 3 less likely to be affected by an external magnetic field can be realized while suppressing the cost.

### Embodiment 2

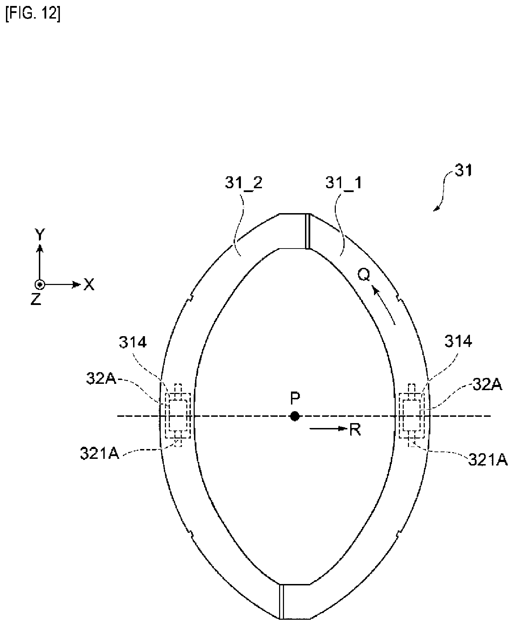

FIGS. 12 to 15 illustrate a configuration of a current sensor 3A according to Embodiment 2.

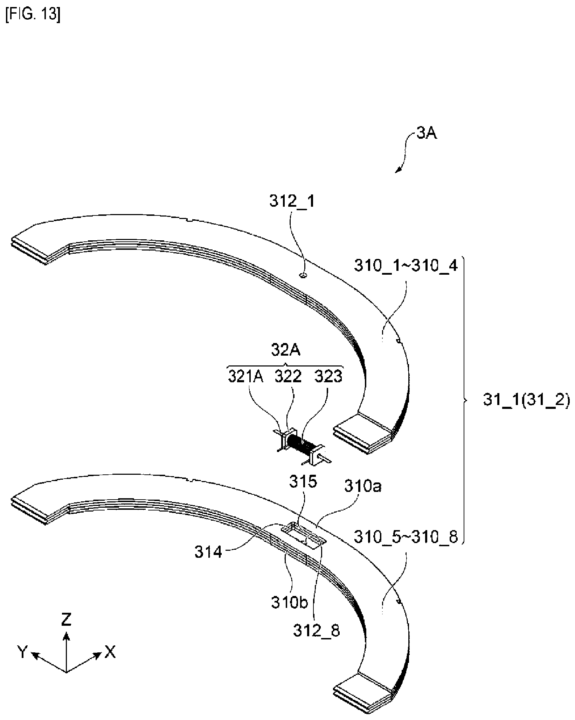

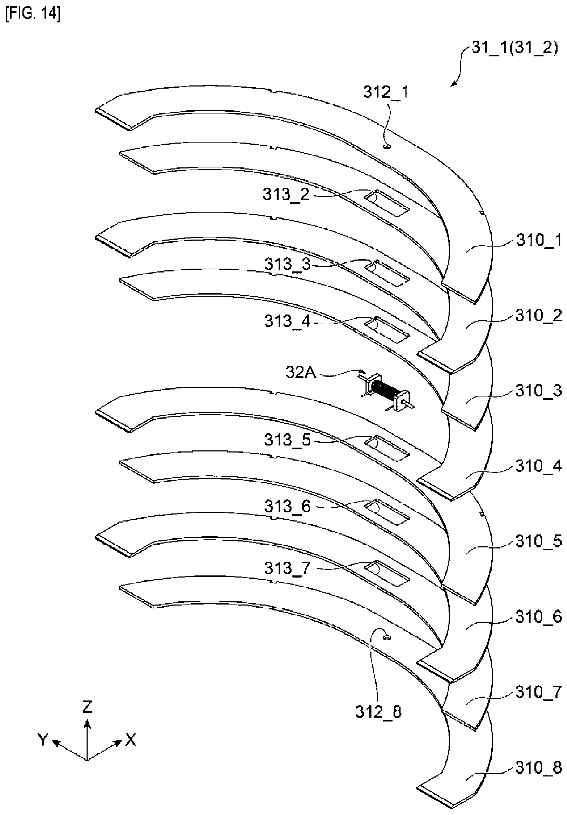

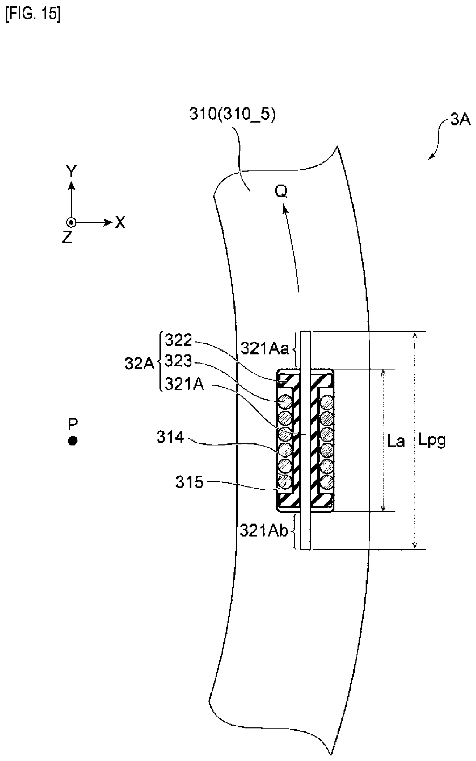

FIGS. 12 to 15 illustrate a case in which, in the three-dimensional space defined by three reference axes including the X-axis, the Y-axis, and the Z-axis, the main core 31_1 is arranged such that the circumferential direction of the main core 31_1 is parallel to the X-Y plane. Specifically, FIG. 12 illustrates a front view of the main core 31_1 and 31_2 having an annular shape. FIG. 13 illustrates an exploded perspective view (partial) of the main core 31_1 (31_2) according to Embodiment 2. FIG. 14 illustrates an exploded perspective view (entire) of the main core 31_1 (31_2) according to Embodiment 2. FIG. 15 illustrates a cross-sectional structure of the fluxgate 32A along the X-Y plane.

The current sensor 3A according to Embodiment 2 differs from the current sensor 3 according to Embodiment 1 in that both end portions 321Aa and 321Ab of a core (second core) 321A constituting a fluxgate 32A are covered by main cores 31_1 and 31_2 (first cores), and is the same as the current sensor 3 according to Embodiment 1 in other respects.

The fluxgate 32A includes, similarly to the fluxgate 32 according to Embodiment 1, the core (an example of a second core) 321A made of a magnetic material. The core 321A is configured in a thin plate shape, similarly to the core 321 according to Embodiment 1. The core 321A is accommodated in a hollow cylinder of a bobbin 322. For example, as illustrated in FIGS. 12 to 15, one end portion 321Aa and the other end portion 321Ab in an extending direction of the core 321A protrude from both ends of the bobbin 322.

As illustrated in FIGS. 12 to 15, the core 321A of the fluxgate 32A extends along a circumferential direction Q of a main core 31 (31_1 and 31_2). Specifically, a portion of the core 321A extends in the accommodation space 314, and the one end portion 321Aa and the other end portion 321Ab in the extending direction of the core 321A protrude from the accommodation space 314 and are covered by the main core 31 (31_1 and 31_2). For example, when the length in the circumferential direction Q of the holes 313_2 to 313_7 formed in the plate-like members 310_2 to 310_7 (310_5) constituting the main core 31 (length in the circumferential direction Q of the accommodation space 314) is defined as La, and the length in the extending direction (circumferential direction Q) of the core 321A of the fluxgate 32A is defined as Lpg, La < Lpg is satisfied.

As illustrated in FIGS. 12 to 15, the one end portion 321Aa in the extending direction of the core 321A of the fluxgate 32A and the other end portion 321Ab of the core 321A in the extending direction are interposed between two plate-like members 310 in an insertion direction of a measurement target 5 in the main core 31. For example, both end portions 321Aa and 321Ab of the core 321A protruding from the bobbin 322 of the fluxgate 32A are interposed between two intermediate-layer plate-like members 310 (for example, 310_4 and a plate-like member 310_5) constituting the main core 31_1. Thus, both end portions 321Aa and 321Ab of the core 321A are covered by the main core 31 and fixed. In particular, since the core 321A is formed in a thin plate shape, the core 321A is easily interposed between two intermediate-layer plate-like members 310 constituting the main core 31_1, and fixing of the core 321A is facilitated. Further, although the core of the fluxgate needs to be brought into a magnetic saturation state in principle, formation of the core 321A into a thin plate shape facilitates bringing the core 321A into the magnetic saturation state.

As described above, according to the current sensor 3A according to Embodiment 2, since the end portions 321Aa and 321Ab of the core 321A are covered by the main core 31, the core 321 of the fluxgate 32A can be reliably brought into contact with the main core 31. Accordingly, since a contact area between the main core 31 and the core 321 becomes large, leakage of magnetic flux can be more reliably prevented. Further, by interposing both the end portions 321Aa and 321Ab of the core 321A between the two plate-like members 310 constituting the main core 31, the fluxgate 32 can be easily fixed inside the main core 31 in a state of being in contact with the main core 31. Accordingly, assembly of the main core 31 and the fluxgate 32 is facilitated.

### Extension of Embodiment

Although the invention by the inventors of the present application has been specifically described based on the embodiment, the present invention is not limited to the embodiment, and it is needless to say that various changes can be made insofar as they do not depart from the scope and gist of the present invention.

For example, in Embodiments 1 and 2 described above, the case in which the main core 31 includes the two fluxgates 32 (32A) as fluxgates is exemplified, but the number of the fluxgates 32 is not limited thereto. Specifically, the main core 31 may have an even number of fluxgates 32 (32A).

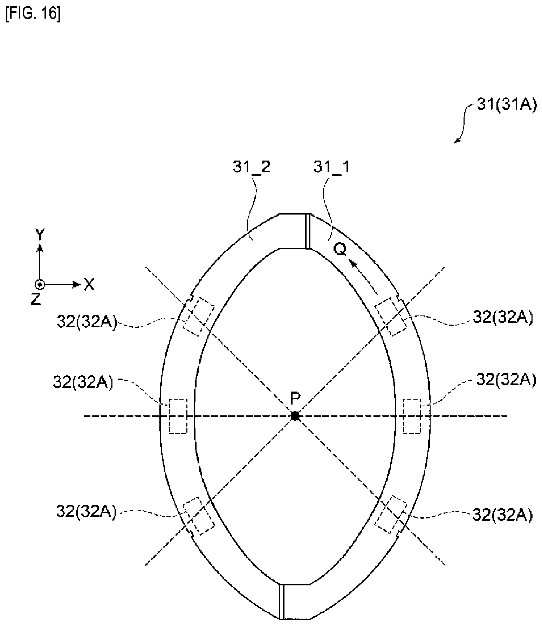

For example, as illustrated in FIG. 16, in a case in which six fluxgates 32 are provided in the main core 31, three accommodation spaces 314 are respectively provided in the main core 31_1 and the main core 31_2, and the fluxgate 32 is respectively arranged in each accommodation space 314. In this case, as illustrated in FIG. 16, one fluxgate 32 (32A) and another fluxgate 32 (32A) may be respectively arranged at positions that are point-symmetric with respect to the center or the centroid P of the main core 31 when the annular main core 31 is viewed from the insertion direction of the measurement target 5 in the main core 31.

Thus, after arranging a plurality of fluxgates 32 (32A), by calculating the average value or the like of the detection results of the respective fluxgates 32 (32A) and using the calculated value as the current detection result, a current sensor with higher accuracy can be realized. That is, by providing a plurality of fluxgates in the main core 31, detection bias due to the position of the measurement target 5 (conductive wire) relative to the main core 31 can be reduced, so that a current sensor having higher detection accuracy can be realized.

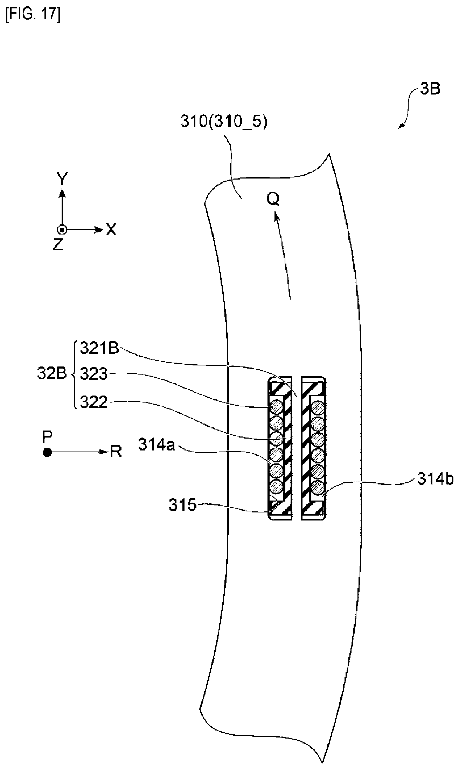

Further, for example, in Embodiments 1 and 2, a case in which the main core 31 and the cores 321 and 321A of the fluxgate 32 are individually formed is exemplified, but the present invention is not limited thereto. For example, as in a current sensor 3B illustrated in FIG. 17, the main core 31 and the core 321B of the fluxgate 32B may be integrally formed. Accordingly, as described below, manufacturing of the current sensor 3B incorporating the fluxgate 32B is facilitated.

An example of a method of manufacturing the fluxgate 32B illustrated in FIG. 17 will be described.
First, in at least one plate-like member 310 (for example, the plate-like member 310_5) constituting the main core 31, two holes 314a and 314b are formed along a Q direction so as to be separated from each other in the radial direction of the plate-like member 310, and a portion of the plate-like member 310 located between the two holes 314a and 314b is defined as a core 321B (second core) of the fluxgate 32B. Next, two halves having shapes obtained by cutting the hollow cylinder of the bobbin 322 in half along the center line or the centroid line are arranged and fixed with the core 321 that is a part of the plate-like member 310 located between the above-described two holes 314a and 314b interposed between the two halves. Next, the coil 323 is wound around the bobbin 322. Finally, the plate-like members 310_1 to 310_8 are stacked in the Z-axis direction.
By integrally forming the main core 31 and the core 321B of the fluxgate 32B in this manner, manufacturing of the current sensor 3B incorporating the fluxgate 32B is facilitated.
Note that, by forming the two holes 314a and 314b in the plurality of plate-like members 310 adjacent to each other, a thicker core 321B (second core) may be realized.

Further, in the above-described Embodiments 1 and 2, a case has been exemplified in which the cores 321 and 321A of the fluxgates 32 and 32A extend in the circumferential direction Q of the main core 31, but the present invention is not limited to this. That is, the cores 321 and 321A of the fluxgates 32 and 32A may extend in a direction different from the circumferential direction Q of the main core 31 (a direction intersecting the circumferential direction Q) and may be in contact with the main core 31.

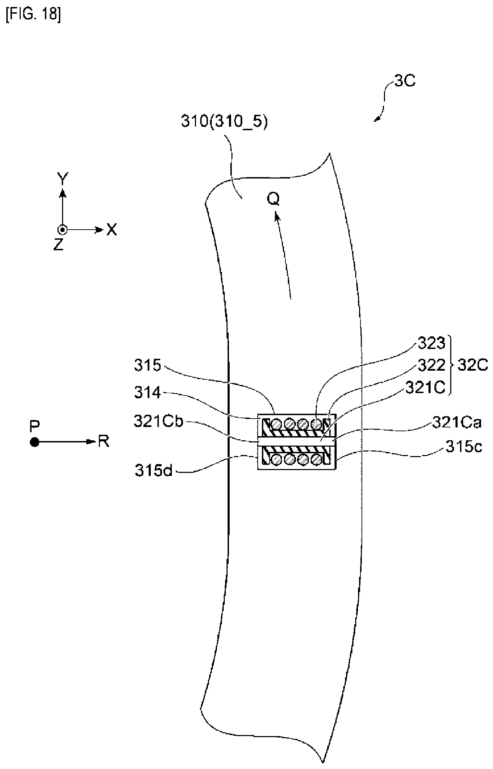

For example, as in a current sensor 3C illustrated in FIG. 18, a core 321C of a fluxgate 32C is arranged to extend along a radial direction R of the annular main core 31. One end portion 321Ca of the core 321C in the extending direction is in contact with one end portion 315c in the radial direction R of the inner wall 315 defining the accommodation space 314. The other end portion 321Cb of the core 321C in the extending direction is in contact with the other end portion 315d in the radial direction R of the inner wall 315.
Note that, similarly to the current sensor 3A, by interposing both the end portions 321Ca and 321Cb of the core 321 between two intermediate-layer plate-like members 310 constituting the main core 31 (for example, 310_4 and the plate-like member 310_5), a structure in which both the end portions 321Ca and 321Cb of the core 321 are inserted into the main core 31 may be realized.

According to this configuration, similarly to the current sensors 3 and 3A according to Embodiments 1 and 2 described above, since an air gap is not formed between the main core 31 and the core 321C of the fluxgate 32C, leakage of magnetic flux is prevented, and a decrease in current detection accuracy is suppressed.

Further, in the above-described embodiments, a case in which the cores 321 (321A, 321B, and 321C) of the fluxgates 32 (32A, 32B, and 32C) are entirely covered by the main core 31 is exemplified, but the present invention is not limited thereto. Specifically, the main core 31 does not need to be continuously provided in the circumferential direction Q around the accommodation space 314, or at least a portion of the main core 31 may be continuously provided in the circumferential direction Q.

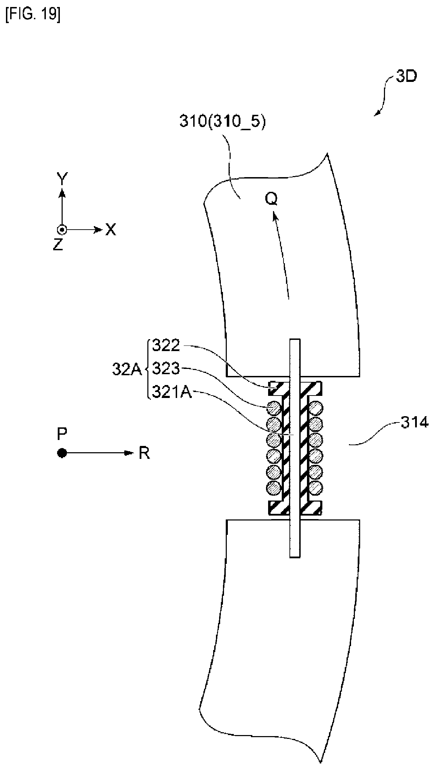

For example, as in the current sensor 3D illustrated in FIG. 19, the core 321A (321) of the fluxgate 32A (32) does not need to be covered by the main core 31 in the radial direction R (X-axis direction) of the main core 31. In other words, on the outer peripheral side and the inner peripheral side of the main core 31 with respect to the accommodation space 314, the main core 31 does not need to be continuously provided in the circumferential direction Q. In this case, in a direction perpendicular to the radial direction R and the circumferential direction Q of the main core 31 (the insertion direction of the measurement target 5 in the main core 31 (the Z-axis direction)), the fluxgate 32 may be covered by the main core 31, or may not be covered by the main core 31.

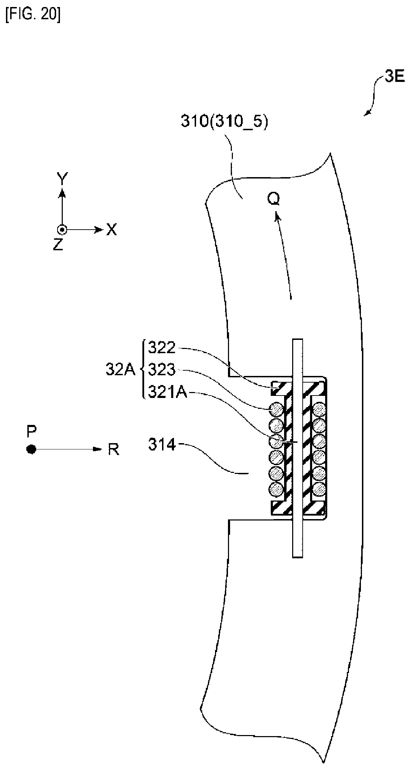

Further, for example, the fluxgate 32 may be covered by the main core 31 only on the outer peripheral side of the main core 31. Specifically, as in a current sensor 3E illustrated in FIG. 20, the main core 31 may be continuously provided in the circumferential direction Q on the outer peripheral side of the accommodation space 314. In this case, in the insertion direction (Z-axis direction) of the measurement target 5 with respect to the main core 31, the fluxgate 32 may be covered by the main core 31, or may not be covered by the main core 31.

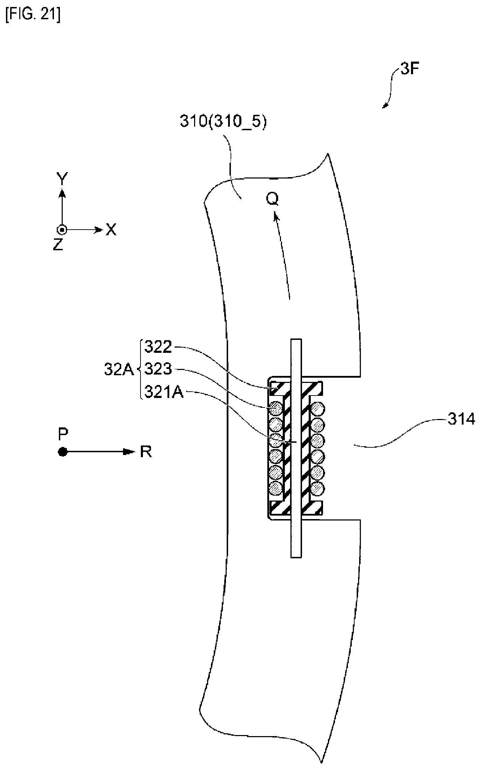

Further, for example, the fluxgate 32 may be covered by the main core 31 only on the inner peripheral side of the main core 31. Specifically, as in a current sensor 3F illustrated in FIG. 21, the main core 31 may be continuously provided in the circumferential direction Q on the inner peripheral side of the accommodation space 314. In this case, in the insertion direction (Z-axis direction) of the measurement target 5 with respect to the main core 31, the fluxgate 32 may be covered by the main core 31, or may not be covered by the main core 31.

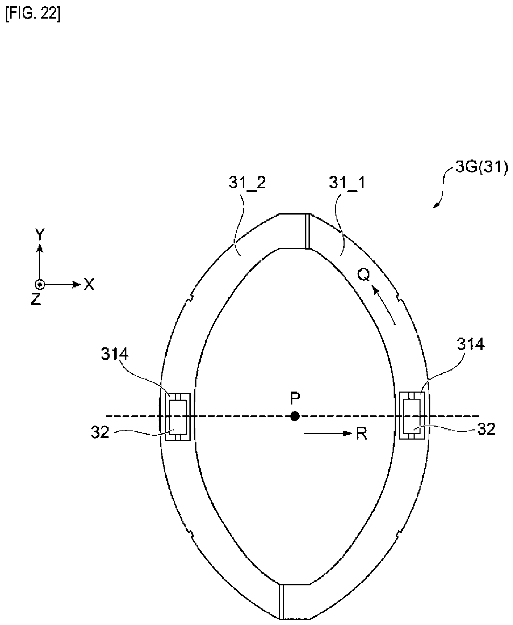

Further, for example, as in a current sensor 3G illustrated in FIG. 22, the fluxgate 32 may be covered by the main core 31 on the outer peripheral side and the inner peripheral side of the main core 31, while the fluxgate 32 may not be covered by the main core 31 in the direction perpendicular to the radial direction R and the circumferential direction Q of the main core 31 (the stacking direction (Z-axis direction) of the main core 31). In other words, an opening may be formed, on at least one of an upper surface (a plate-like member 310_1) and a lower surface (a plate-like member 310_8) of the main core 31, in a region overlapping the accommodation space 314 when viewed in a Z-axis direction.

Further, for example, the magnetic permeability of the magnetic material constituting the core 321 (321A and 321C) of the fluxgate 32 (32A and 32C) may be greater than the magnetic permeability of the magnetic material constituting the main core 31_1 (31_2). Accordingly, since magnetic flux easily passes through the core 321 (321A and 321C) of the fluxgate 32 (32A and 32C), a current sensor having higher sensitivity can be realized.

Further, for example, all of the plurality of plate-like members 310_1 to 310_n constituting the main core 31_1 (31_2) may be integrally formed. According to this, the number of components is reduced, and therefore, the number of manufacturing steps can be reduced.

Further, in the above-described embodiments, a case in which the signal generation circuit 50A (50) is provided in the current sensor 3 is exemplified, but the signal generation circuits 50 and 50A may be incorporated in the measurement device main body 2. In this case, the current sensor 3 (3A to 3G) may include at least the main core 31 and the fluxgate 32 (32, 32A, 32B, and 32C).

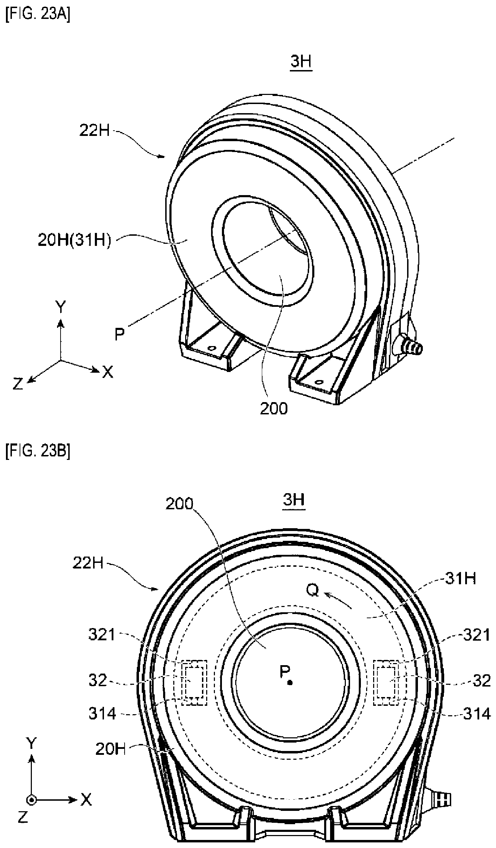

Further, in the above-described embodiments, a case in which the current sensor 3 and the like are clamp-type current sensors having the main core 31 deformable into an annular shape is described, but the present invention is not limited thereto, and the current sensor 3 and the like may be so-called through-type current sensors having the main core 31 formed in an annular shape, as illustrated in FIGS. 23A and 23B.

A through-type current sensor 3H illustrated in FIGS. 23A and 23B differs from the above-described clamp-type current sensors 3 and the like in that a sensor portion (the main core) is not deformable, and is the same as the other current sensors 3 and the like in other respects. For example, the current sensor 3H is used by inserting the measurement target 5 (conductive wire) into an insertion hole 200 of an annular sensor portion 22 along the insertion direction and then fixing the current sensor 3H at an installation location.

In the current sensor 3H, a sensor portion 22H includes a main core 31H formed in an annular shape and a case 20H covering the main core 31H. In the accommodation space 314 of the main core 31H, the fluxgate 32 is provided, and both end portions of the core (second core) 321 are in contact with the main core 31H. The main core 31 may be formed of one annular magnetic member, or, as illustrated in FIG. 6, may be formed by coupling a plurality of magnetic members (main cores 31_1 and 31_2). Further, as the configuration of the fluxgate 32 in the current sensor 3H and the configuration of the main core 31 around the fluxgate 32, the same configuration as any one of the above-described current sensors 3, 3A, 3B, 3C, 3D, 3E, 3F, and 3G may be adopted.

According to the current sensor 3H, as with the current sensors 3 and the like according to other embodiments, improvement in current detection accuracy can be expected.

Further, in the above-described embodiments, as illustrated in FIG. 6, a case in which the main core 31 is realized by coupling two magnetic members (the main cores 31_1 and 31_2) is exemplified, but the present invention is not limited thereto. For example, the main core 31 may be realized by one magnetic member, or the main core 31 may be realized by coupling three or more magnetic members.

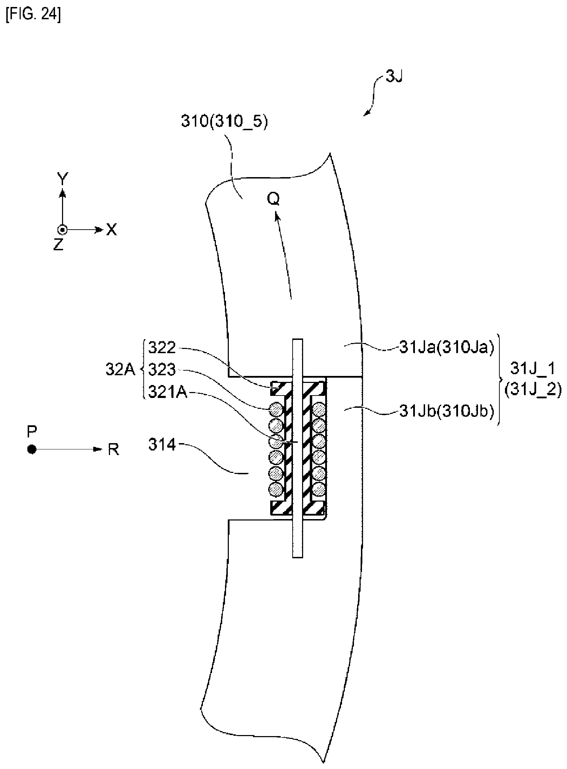

Further, at least one of the main core 31_1 and the main core 31_2 may be constituted by a plurality of magnetic members. For example, as in a current sensor 3J illustrated in FIG. 24, the main core 31J_1 may be constituted by a first magnetic member 31Ja (plate-like member 310Ja) and a second magnetic member 31Jb (plate-like member 310Jb). In this case, the first magnetic member 31Ja and the second magnetic member 31Jb may be in contact with each other in the circumferential direction of the main core 31J_1. Further, when the main core 31 is realized by the plurality of magnetic members, the magnetic members may be made of different types of magnetic materials from each other.

In the above-described embodiments, the current sensor using one fluxgate has been exemplified, but the present invention is not limited thereto. For example, the technical features of the present invention can be adopted in a current sensor using a fluxgate pair including two fluxgates as one set. Hereinafter, the details will be described with reference to the drawings.

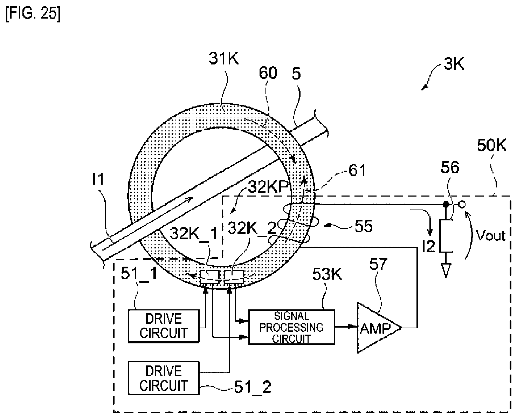

FIG. 25 is a diagram illustrating a circuit example of a magnetic balance type current sensor 3K using a fluxgate pair including two fluxgates as one set.

As illustrated in FIG. 25, the current sensor 3K includes a main core 31K, a fluxgate pair 32KP including two fluxgates 32K_1 and 32K_2 as one set, and a signal generation circuit 50K.

At least one fluxgate pair 32KP is provided in the current sensor 3K. The fluxgate 32K_1 and the fluxgate 32K_2 constitute a differential-type fluxgate pair 32KP. That is, the fluxgates 32K_1 and 32K_2 are arranged on the main core 31K such that the magnetic fluxes excited from the fluxgate 32K_1 and the fluxgate 32K_2 are generated in the directions facing each other.

The signal generation circuit 50K includes, for example, drive circuits 51_1 and 51_2, a signal processing circuit 53K, the amplification circuit (AMP) 57, the coil 55 (a feedback winding) wound around the main core 31, and the voltage generation circuit (for example, a shunt resistor) 56. The fluxgate 32K_1 is operable by power supplied from the drive circuit 51_1. The fluxgate 32K_2 is operable by power supplied from the drive circuit 51_2. The fluxgates 32K_1 and 32K_2 detect the magnetic flux 60 generated by the current I1 flowing through the measurement target 5, and generate voltages corresponding to the detected magnetic flux 60. The fluxgates 32K_1 and 32K_2 generate voltages having opposite phases to each other. The signal processing circuit 53K generates voltages obtained by subjecting respective voltages generated by the fluxgates 32K_1 and 32K_2 to synchronous detection or pulse width modulation, converts the generated voltages into currents, and outputs the currents.

The amplification circuit 57 supplies the current I2 to the coil 55 based on the current output from the signal processing circuit 53 so as to generate the magnetic flux 61 that cancels the magnetic flux 60 (magnetic flux due to the current I1) detected by the fluxgates 32K_1 and 32K_2 (zero flux operation). The voltage generation circuit (for example, a shunt resistor) 56 converts the current I2 flowing through the coil 55 into a voltage and outputs the voltage as an output signal Vout.

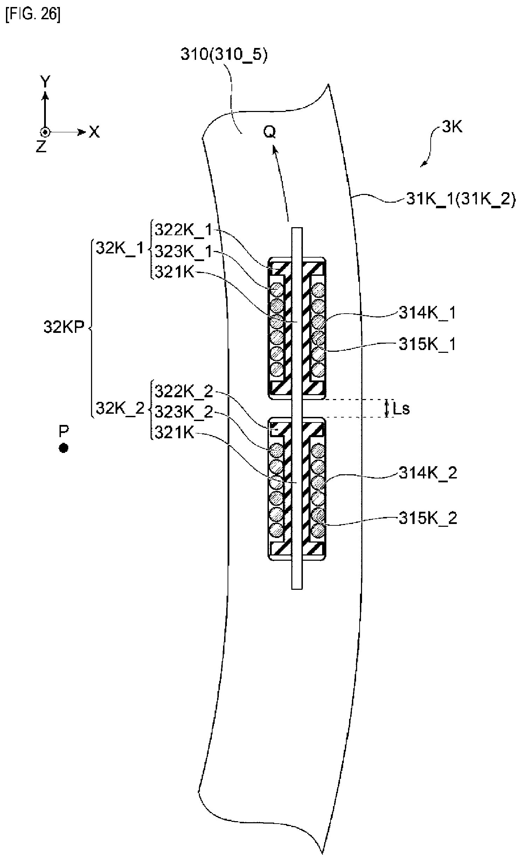

FIG. 26 is a diagram illustrating a configuration of the magnetic balance type current sensor 3K using a fluxgate pair including two fluxgates as one set.

FIG. 26 illustrates a cross-sectional structure along the X-Y plane of the fluxgates 32K_1 and 32K_2 in the current sensor 3K.

The current sensor 3K differs from the current sensor 3 according to Embodiment 1 in that the current sensor 3K includes at least one fluxgate pair 32KP including two fluxgates 32K_1 and 32K_2 as one set, and in other respects, the current sensor 3K is the same as the current sensor 3A according to Embodiment 2. In FIG. 26, as one example, a portion of the current sensor 3K on the main core 31K_1 side is typically illustrated.

The fluxgate 32K_1 and the fluxgate 32K_2 constituting the fluxgate pair 32KP share the core 321K. In other words, the fluxgate 32K_1 and the fluxgate 32K_2 have one common core 321K.

The core 321K is constituted by the magnetic material having a rod shape or a strip shape (thin plate shape), similarly to the core 321 and the like according to Embodiment 1. For example, as illustrated in FIG. 26, the core 321K extends along the circumferential direction Q of the main core 31K.

The coil 323K_1 of the fluxgate 32K_1 and the coil 323K_2 of the fluxgate 32K_2 are respectively wound around the core 321K shared by the fluxgate 32K_1 and the fluxgate 32K_2. Specifically, the coil 323K_1 and the coil 323K_2 are respectively wound around the core 321K with bobbins interposed between the coil 323K_1 and the core 321K and between the coil 323K_2 and the core 321K.

More specifically, the fluxgates 32K_1 and 32K_2 include bobbins 322K_1 and 322K_2, respectively. As illustrated in FIG. 26, the bobbins 322K_1 and 322K_2 are arranged side by side so that the circumferential direction Q of the main core 31K is parallel to the center line or the centroid line of the hollow cylinder of each of the cylindrical bobbins 322K_1 and 322K_2. The core 321K is inserted into the hollow cylinders of the bobbins 322K_1 and 322K_2 along the center line or the centroid line of the hollow cylinders of the bobbins 322K_1 and 322K_2. The coil 323K_1 is wound around the outer peripheral surface of the bobbin 322K_1, and the coil 323K_2 is wound around the outer peripheral surface of the bobbin 322K_2.

The fluxgate 32K_1 and the fluxgate 32K_2 are arranged in different accommodation spaces. As illustrated in FIG. 26, an accommodation space 314K_1 accommodating the fluxgate 32K_1 and an accommodation space 314K_2 accommodating the fluxgate 32K_2 are formed in the main core 31K_1 (31K_2), respectively.

Here, the accommodation space 314K_1 and the accommodation space 314K_2 are preferably formed apart from each other in the circumferential direction Q of the core 321K. In other words, the core 321K (magnetic material) is continuously formed between the accommodation space 314K_1 and the accommodation space 314K_2. Here, when a distance between the accommodation space 314K_1 and the accommodation space 314K_2 is defined as Ls, 1.0 mm ≤ Ls ≤ 10.0 mm is preferable. More preferably, 1.0 mm ≤ Ls ≤ 5.0 mm.

In this case, the main core 31K is preferably formed continuously in the circumferential direction Q of the main core 31K on at least one of the outer peripheral side and the inner peripheral side of the accommodation spaces 314K_1 and 314K_2 (see FIGS. 20 and 21). FIG. 26 illustrates, as one example, a case in which the main core 31K is continuously formed in the circumferential direction Q on both the outer peripheral side and the inner peripheral side of the accommodation spaces 314K_1 and 314K_2. Note that, in the insertion direction of the measurement target 5 in the main core 31 (Z-axis direction), the fluxgates 32K_1 and 32K_2 (the accommodation spaces 314K_1 and 314K_2) may be covered by the main core 31K, or may not be covered by the main core 31K.

As illustrated in FIG. 26, the bobbin 322K_1, around which the coil 323K_1 is wound and through which the core 321K is inserted, is accommodated in the accommodation space 314K_1, and the bobbin 322K_2, around which the coil 323K_2 is wound and through which the core 321K is inserted, is accommodated in the accommodation space 314K_2. As a result, the fluxgate 32K_1 and the fluxgate 32K_2 are arranged side by side in the circumferential direction Q of the main core 31K, with the magnetic material serving as the main core 31K_1 (31K_2) interposed between the fluxgate 32K_1 and the fluxgate 32K_2. In this case, winding directions of the coil 323K_1 and the coil 323K_1 are preferably determined such that the magnetic fluxes respectively excited by the fluxgate 32K_1 and the fluxgate 32K_2 are generated in the directions facing each other.

As described above, the current sensor 3K includes the fluxgate pair 32KP including the coils 323K_1 and 323K_2 respectively wound around the single shared core 321K. Accordingly, voltages generated from the coils 323K_1 and 323K_2 of the fluxgates 32K_1 and 32K_2 are suppressed from being superimposed, as noise, on the main core 31 and the coil 55 (feedback winding) wound around the main core 31 via the parasitic capacitance. For example, by arranging the fluxgate pair 32KP such that the fluxgates 32K_1 and 32K_2 generate voltages having opposite phases, the noise generated from the fluxgate 32K_1 can be canceled by the noise generated from the fluxgate 32K_1. Accordingly, noise superimposed on the main core 31 and the coil 55 (feedback winding) can be reduced, and the current detection accuracy by the current sensor 3K can be improved.

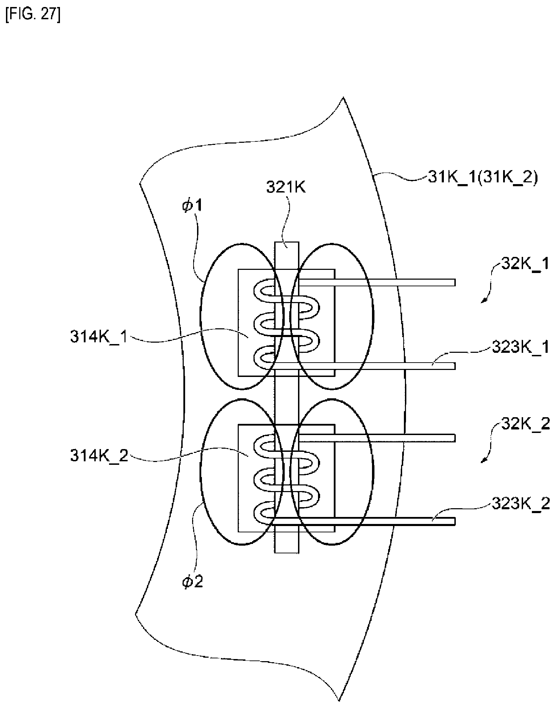

Further, in the current sensor 3K, the accommodation space 314K_1 accommodating the fluxgate 32K_1 and the accommodation space 314K_2 accommodating the fluxgate 32K_2 are formed side by side in the circumferential direction Q of the main core 32K, and the main core 31K is continuously formed between the accommodation space 314K_1 and the accommodation space 314K_2.
According to this, even in a case in which the fluxgate pair 32KP is arranged such that the fluxgates 32K_1 and 32K_2 generate voltages having opposite phases, the cancellation of the magnetic fluxes respectively excited by the coil 323K_1 of the fluxgate 32K_1 and the coil 323K_2 of the fluxgate 32K_2 can be prevented. That is, as illustrated in FIG. 27, by the magnetic material (main core 31K) being present between the accommodation space 314K_1 and the accommodation space 314K_2, and the magnetic fluxes Φ1 and Φ2 generated from each of the coils 323K_1 and 323K_2 are formed to pass through the main core 32K present around the fluxgates 32K_1 and 32K_2. Accordingly, the magnetic fluxes Φ1 and Φ2 form loop shapes, and the cancellation of the magnetic fluxes Φ1 and Φ2 with each other can be prevented, so that a current sensor having a differential fluxgate pair is easily realized.

Further, by setting the distance Ls between the accommodation space 314K_1 and the accommodation space 314K_2 to satisfy 1.0 mm ≤ Ls ≤ 10.0 mm, the two coils 323K_1 and 323K_2 of the fluxgate pair 32KP can be brought closer to each other, and noise superimposed on the main core 31 and the coil 55 can be further reduced. Further, by setting 1.0 mm ≤ Ls ≤ 5.0 mm, the two coils 323K_1 and 323K_2 of the fluxgate pair 32KP can be brought closer to each other, so that the noise superimposed on the main core 31 and the coil 55 can be further reduced.

Note that, as illustrated in FIG. 26, a case is illustrated in which, similarly to the core 321A according to Embodiment 2, a portion of the core 321K extends in the accommodation spaces 314K_1 and 314K_2, and one end portion and the other end portion in the extending direction of the core 321A protrude from the accommodation spaces 314K_1 and 314K_2, but is not limited thereto. For example, similarly to the core 321 according to Embodiment 1, the one end portion in the extending direction of the core 321K may be in contact with one surface in the circumferential direction Q of the inner wall 315K_1 of the main core 31K defining the accommodation space 314K_1, and the other end portion in the extending direction of the core 321K may be in contact with the other surface in the circumferential direction of the inner wall 315K_2 of the main core 31K defining the accommodation space 314K_2. Further, as in the current sensor 3B, the main core 31K and the core 321K of the fluxgates 32K_1 and 32K_2 may be integrally formed.

### REFERENCE SIGNS LIST

1: Measurement device, 2: Measurement device main body, 3, 3A to 3H, 3J, 3K: Current sensor, 5: Measurement target, 11: Measurement section, 12: Operation interface, 13: Display section, 14: Control section, 15: Storage section, 21: Gripping portion, 22: Sensor portion, 22_1: First sensor portion, 22_2: Second sensor portion, 23: Connection cable, 25_1, 25_2: Magnetic detection portion, 26: Coil, 31, 31_1, 31_2, 31J, 31K: Main core (first core), 31Ja: First magnetic member, 31Jb: Second magnetic member, 32, 32A, 32B, 32C, 32K_1, 32K_2: Fluxgate, 32KP: Fluxgate pair, 50, 50A, 50K: Signal generation circuit, 51, 51_1, 51_2: Drive circuit, 52, 53, 53K: Signal processing circuit, 54, 57: Amplification circuit, 55: Coil, 56: Voltage generation circuit, 310, 310_1 to 310_8, 310Ja, 310Jb: Plate-like member, 312_1, 312_8: Hole, 313_2 to 313_7: Hole, 314, 314K_1, 314K_2: Accommodation space, 315, 315K_1, 315K_2: Inner wall, 321, 321A, 321B, 321C, 321K: Core (second core), 322, 322K_1, 322K_2: Bobbin, 323, 323K_1, 323K_2: Coil (winding)

## Claims

1. A current sensor comprising:
a fluxgate configured to detect magnetic flux;
a first core made of a magnetic material, the first core having an annular configuration and including an accommodation space configured to accommodate the fluxgate; and
a signal generation circuit configured to generate a signal based on magnetic flux detected by the fluxgate, the current sensor configured to detect a current flowing through a measurement target in a state with the measurement target inserted through the first core,
wherein the fluxgate includes a second core made of a magnetic material and extending in the accommodation space and a coil wound around the second core along an extending direction of the second core, one end portion of the second core in the extending direction being in contact with a portion of the first core, and the other end portion of the second core in the extending direction being in contact with another portion of the first core.

2. The current sensor according to claim 1,
wherein the second core extends in a circumferential direction of the first core.

3. The current sensor according to claim 1 or 2,
wherein the first core is continuously provided in the circumferential direction of the first core on an outer peripheral side of the first core around the accommodation space.

4. The current sensor according to any one of claims 1 to 3,
wherein the first core is continuously provided in the circumferential direction of the first core on an inner peripheral side of the first core around the accommodation space.

5. The current sensor according to any one of claims 1 to 4,
wherein, when one surface of the first core in an insertion direction of the measurement target in the first core is defined as an upper surface and the other surface in the insertion direction of the measurement target in the first core is defined as a lower surface, the first core is continuously provided in the circumferential direction of the first core on at least one surface of the upper surface or the lower surface around the accommodation space.

6. The current sensor according to any one of claims 3 to 5,
wherein a portion of the first core continuously provided in the circumferential direction is integrally formed.

7. The current sensor according to any one of claims 1 to 6,
wherein the one end portion of the second core in the extending direction and the other end portion of the second core in the extending direction are covered by the first core.

8. The current sensor according to any one of claims 1 to 7,
wherein the first core is formed by a plurality of plate-like members made of a magnetic material, each of the plurality of plate-like members being stacked in an insertion direction of the measurement target in the first core, the one end portion of the second core in the extending direction and the other end portion of the second core in the extending direction being interposed between two plate-like members of the plurality of plate-like members in the insertion direction.

9. The current sensor according to any one of claims 1 to 8, comprising:
a plurality of the fluxgates.

10. The current sensor according to claim 9, comprising:
at least one fluxgate pair including two fluxgates of the plurality of the fluxgates as one set,
wherein a first fluxgate and a second fluxgate constituting one of the at least one fluxgate pair share the second core, and the coil of the first fluxgate and the coil of the second fluxgate being respectively wound around the second core shared by the first fluxgate and the second fluxgate.

11. The current sensor according to claim 10,
wherein the accommodation space includes a first accommodation space configured to accommodate the first fluxgate and a second accommodation space configured to accommodate the second fluxgate, the first accommodation space and the second accommodation space being provided side by side in a circumferential direction of the first core, and the first core being continuously provided between the first accommodation space and the second accommodation space.

12. The current sensor according to any one of claims 1 to 11,
wherein the first core and the second core are integrally formed.

13. The current sensor according to any one of claims 1 to 12,
wherein the current is detected by a zero flux method.

14. A measurement device comprising:
the current sensor according to any one of claims 1 to 13; and
a measurement device main body configured to measure a current flowing through the measurement target, based on the signal generated by the current sensor.

15. A measurement method for measuring a current flowing through a measurement target by using a current sensor, the current sensor including a fluxgate configured to detect magnetic flux, a first core made of a magnetic material, the first core having an annular configuration and including an accommodation space configured to accommodate the fluxgate, and a signal generation circuit configured to generate a signal based on magnetic flux detected by the fluxgate, the fluxgate including a second core made of a magnetic material, the second core extending in the accommodation space, and a coil wound around the second core along an extending direction of the second core, one end portion of the second core in the extending direction being in contact with a portion of the first core and the other end portion of the second core in the extending direction being in contact with another portion of the first core, the measurement method comprising:
a first step of inserting the measurement target through the first core; and
a second step of measuring the current flowing through the measurement target, based on the signal generated by the signal generation circuit.
